Europäisches Patentamt

European Patent Office

Office européen des brevets

(19)

(11) **EP 0 722 651 B1**

(12)

# FASCICULE DE BREVET EUROPEEN

(45) Date de publication et mention
de la délivrance du brevet:
**29.04.1998 Bulletin 1998/18**

(21) Numéro de dépôt: **94928943.3**

(22) Date de dépôt: **04.10.1994**

(51) Int Cl.⁶: **H05H 1/46**

(86) Numéro de dépôt international:
**PCT/FR94/01155**

(87) Numéro de publication internationale:
**WO 95/10169 (13.04.1995 Gazette 1995/16)**

(54) **DISPOSITIF ET PROCEDE POUR FORMER UN PLASMA PAR APPLICATION DE MICRO-ONDES**

VORRICHTUNG UND VERFAHREN ZUR PLASMAERZEUGUNG DURCH VERWENDUNG VON MIKROWELLEN

DEVICE AND METHOD FOR FORMING A MICROWAVE PLASMA

(84) Etats contractants désignés:
**BE CH DE ES FR GB IT LI NL SE**

(30) Priorité: **04.10.1993 FR 9311785**

(43) Date de publication de la demande:
**24.07.1996 Bulletin 1996/30**

(73) Titulaire: **PLASMION**
**91892 Orsay Cédex (FR)**

(72) Inventeurs:
- **WARTSKI, Louis**
  **F-92120 Montrouge (FR)**
- **AUBERT, Jean**
  **F-78470 Saint-Rémy-les-Chevreuse (FR)**

(74) Mandataire: **Leszczynski, André et al**
**NONY & ASSOCIES**
**29, rue Cambacérès**
**75008 Paris (FR)**

(56) Documents cités:
**EP-A- 0 391 156**

- **REVIEW OF SCIENTIFIC INSTRUMENTS, vol.59, no.7, Juillet 1988, NEW YORK US pages 1072 - 1075, XP2062 PICHOT ET AL. 'Microwave multipolar plasmas excited by distributed electron cyclotron resonance: Concept and performance'**
- **IEEE TRANSACTIONS ON PLASMA SCIENCE, vol.18, no.4, Août 1990, NEW YORK US pages 717 - 724 NGO PHON LINH ET AL. 'Excitation of the half-frequency of the input signal in the response of an antenna immersed in a plasma'**
- **PATENT ABSTRACTS OF JAPAN vol. 14, no. 411 (E-973) 5 Septembre 1990 & JP,A,02 156 526 (NEC CORP.) 15 Juin 1990**
- **REVIEW OF SCIENTIFIC INSTRUMENTS, vol.65, no.4/2, Avril 1994, NEW YORK US pages 1101 - 1103 FARCHI ET AL. 'Optimization of a two-stages electrostatic reflex ion source (5th Int. Conf. on Ion Sources, Beijing, China, 31/8-4/9 1993)'**

**Description**

La présente invention concerne un dispositif et un procédé pour former un plasma par application de micro-ondes.

Pour créer un plasma, il est connu de soumettre un volume de gaz à une excitation à haute fréquence par un champ électrique alternatif, en combinaison éventuelle avec un champ magnétique statique.

Cette superposition d'un champ électrique alternatif et d'un champ magnétique statique provoque un effet de résonance électronique cyclotron, assurant les conditions optimales d'ionisation du gaz.

Dans la pratique, on crée un plasma à partir d'un volume de gaz en plaçant ledit volume de gaz dans un champ électrique alternatif à haute fréquence généré par une antenne métallique, et auquel on superpose éventuellement un champ magnétique statique. Le document JP-A-2156526 décrit un dispositif pour former un plasma comportant une pluralité d'antennes parallèles entre-elles, situées dans un même plan.

Le document Review of Scientific Instruments, vol. 59 N°7, Juillet 1988, New-York, Etats-Unis, pages 1072 à 1075, XP2062 comprend un article intitulé "Plasma multipolaire à micro-ondes excité par résonnance cyclotron électronique distribuée. Concept et performances" de Messieurs PICHOT et AL qui décrit le principe de fonctionnement d'un dispositif pour former un plasma à partir de micro-ondes en utilisant plusieurs antennes, ce dispositif ne permettant pas cependant d'obtenir un plasma homogène de grande dimension et de forme quelconque.

La présente invention vise à proposer un nouveau dispositif pour former un plasma qui soit de grande dimension et de forme quelconque, notamment en présentant une section rectangulaire ou circulaire.

La présente invention a pour objet un dispositif pour former un plasma à partir de micro-ondes, comportant une chambre d'ionisation dans laquelle un gaz peut être introduit pour subir une excitation due à la présence d'un champ électrique alternatif à haute fréquence émis par une pluralité d'antennes métalliques, caractérisé par le fait qu'il comporte un volume exempt de gaz dans lequel lesdites antennes métalliques sont disposées parallèles les unes aux autres en étant réparties aux noeuds d'un réseau plan régulier, une extrémité de chaque antenne dépassant dudit volume exempt de gaz dans la chambre d'ionisation, une boucle d'induction émettant des micro-ondes dans le volume exempt de gaz.

Selon l'invention, seules les extrémités des antennes sont plongées dans le plasma micro-ondes duquel le faisceau d'ions est extrait.

L'avantage de ce dispositif tient au fait que le plasma, qui occupe un faible volume comparé au volume total, modifie peu les conditions d'excitation de celui-ci.

En outre, l'énergie micro-ondes est apportée à la structure périodique en un unique point dans le volume contenant les antennes par l'intermédiaire d'une boucle d'induction.

Selon l'invention, on entend par boucle d'induction tout moyen permettant d'apporter l'énergie micro-ondes à la structure périodique. Il s'agit notamment d'une antenne annexe.

Ce principe permet de construire des dispositifs très variés selon la position des antennes réparties sur deux dimensions, mais dont la longueur est, selon l'invention, voisine d'un multiple impair du quart de la longueur d'onde de la micro-onde dans le vide.

La surface émissive du plasma, et par conséquent la forme de la section du faisceau d'ions extraits, pourront être choisies pour s'appliquer à de nombreuses applications industrielles, notamment aux traitements de surfaces par faisceaux d'ions.

Dans un mode de réalisation particulier de l'invention, le dispositif comporte en outre des moyens pour générer dans le volume exempt de gaz un champ électrique de polarisation apte à concentrer les ions formés au voisinage de l'ensemble d'antennes métalliques.

Avantageusement, les moyens pour générer le champ électrique de polarisation comprennent l'ensemble d'antennes métalliques qui sert à l'application des micro-ondes dans le plasma.

La présente invention a également pour objet un procédé pour former un plasma à partir de micro-ondes dans un dispositif tel que décrit ci-dessus, caractérisé par le fait que l'on ajoute au champ électrique d'excitation un autre champ électrique de polarisation, quasi statique, tendant à concentrer les ions autour de chacune des antennes émettant les micro-ondes. Dans la théorie des plasmas, cette concentration des ions est désignée sous le terme de gaine d'ions.

En d'autres termes, le procédé selon l'invention consiste à ajouter aux champs électrique et magnétique d'excitation un autre champ électrique de polarisation, quasi statique, qui forme une gaine d'ions autour de l'ensemble d'antennes émettant les micro-ondes.

Cette gaine d'ions se comporte comme une capacité électrique qui vient compenser la composante auto-inductive de l'antenne, laquelle composante auto-inductive apparaît naturellement lorsque le plasma est soumis au micro-ondes, et principalement dans les conditions de résonance électronique cyclotron.

Dans un mode de mise en oeuvre de l'invention, le champ de polarisation est émis par l'ensemble des antennes métalliques, une tension de polarisation étant appliquée directement sur ledit ensemble d'antennes.

Dans une variante préférée, on crée une autopolarisation des antennes par interposition d'une résistance électrique entre les parois de la chambre d'ionisation et une base électriquement conductrice commune à l'ensemble des antennes.

Dans le but de mieux faire comprendre l'invention on va en décrire maintenant un mode de réalisation pris comme exemple non limitatif en référence au dessin annexé dans lequel :

- la figure 1 représente schématiquement et en coupe une chambre d'ionisation selon l'invention,
- la figure 2 est une vue en coupe selon II-II sur la figure 1 de la chambre d'ionisation, et
- la figure 3 est une vue analogue à la figure 2 qui représente une variante de l'ensemble d'antennes de la figure 1.

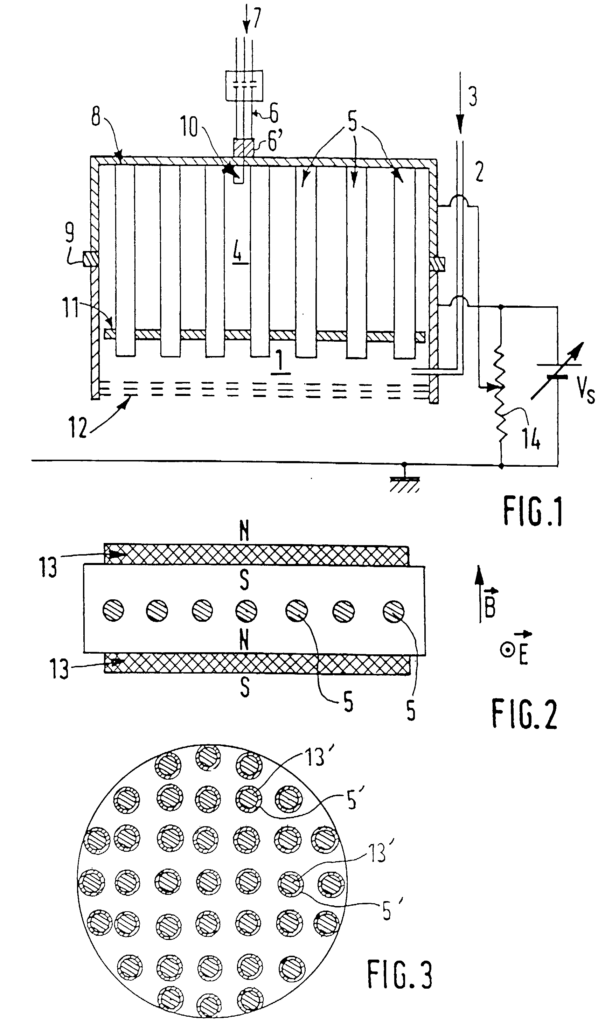

La figure 1 illustre schématiquement une chambre d'ionisation 1, qui présente, selon l'invention, une forme parallélépipédique de grande dimension, à l'intérieur de laquelle un gaz peut être introduit par un conduit 2, comme indiqué par la flèche 3.

A l'intérieur de la chambre 4, un ensemble d'antennes métalliques 5, qui présentent ici la forme de barreaux cylindriques, émet des ondes alternatives à très haute fréquence issues d'un générateur non représenté, et véhiculées jusqu'à l'ensemble d'antennes 5 par un câble coaxial 6, comme indiqué par la flèche 7.

Les antennes de l'ensemble 5 sont disposées suivant une périodicité spatiale, c'est-à-dire aux noeuds d'un réseau plan régulier, et sont électriquement reliées entre elles par un couvercle 8 sur lequel le connecteur 6' d'alimentation micro-ondes est également monté.

Le couvercle d'entrée 8 est isolé du reste de la paroi du dispositif par un isolant 9. La séparation entre ces deux parties est située à une cote où le courant micro-onde circulant sur les parois internes est pratiquement nul, ce qui rend négligeable la perturbation ainsi obtenue.

Dans le cas d'une micro-onde de fréquence 2,45 GHz, le matériau isolant est ainsi situé à une distance de $\lambda/4 \cong 3$ cm de la base des barreaux, dont la longueur est voisine de $k\lambda/4 \cong$ (k impair), ici k=3, et $k\lambda/4 \cong 9$ cm.

Le couvercle 8 sur lequel sont fixées les antennes reçoit le connecteur coaxial d'entrée 6' destiné à transmettre l'énergie micro-onde à cette structure périodique d'antennes. Ce connecteur 6' se termine par une boucle d'induction 10 qui couple l'énergie micro-onde à la structure périodique d'antennes.

Une plaque diélectrique 11 maintient l'extrémité libre des branches des antennes constituant l'ensemble 5, tout en ménageant un important volume exempt de plasma 4.

Un champ électrique alternatif s'établit entre l'ensemble d'antennes 5 et une grille collectrice 12 située en regard des antennes 5.

Des aimants permanents 13 génèrent dans la chambre d'ionisation 1 un champ magnétique statique $\vec{B}$ qui vient se superposer au champ électrique alternatif $\vec{E}$ généré par l'ensemble d'antennes 5.

La figure 2 montre la présence des barres d'aimants permanents 13 de forme parallélépipédique, situées de part et d'autre de la chambre d'ionisation, et produisant un champ magnétique statique $\vec{B}$ transversal dans la direction parallèle à la petite dimension de la chambre.

Le gaz qui pénètre dans la chambre d'ionisation 1 est soumis à une excitation à haute fréquence combinée à un champ magnétique, ce qui provoque son ionisation dans les conditions souhaitées.

Une tension de polarisation est également appliquée à l'ensemble d'antennes 5 par un générateur $V_s$. Cette tension de polarisation provoque la formation, autour de l'ensemble d'antennes 5, d'une gaine d'ions qui constitue l'équivalent d'une capacité électrique.

Un dispositif simple à mettre en oeuvre est l'autopolarisation des antennes par une résistance électrique ajustable 14 placée entre l'ensemble d'antennes 5 et les parois de la chambre d'ionisation.

Sur la figure 3, le volume contenant l'ensemble d'antennes 5' est de section circulaire.

Dans cette configuration, le champ magnétique statique est créé par des aimants permanents 13' en forme de barreaux à aimantation axiale et logés à l'intérieur même des antennes métalliques 5' en forme de tubes creux.

Il est bien entendu que les modes de réalisation qui viennent d'être décrits ne présentent aucun caractère limitatif, et qu'ils pourront recevoir toutes modifications désirables sans sortir pour cela du cadre de l'invention, tel que défini par les revendications.

## Revendications

1. Dispositif pour former un plasma à partir de micro-ondes, comportant une chambre d'ionisation dans laquelle un gaz peut être introduit pour subir une excitation due à la présence d'un champ électrique alternatif à haute fréquence émis par une pluralité d'antennes métalliques, caractérisé par le fait qu'il comporte un volume exempt de gaz (4) dans lequel lesdites antennes métalliques (5,5') sont disposées parallèles les unes aux autres en étant réparties aux noeuds d'un réseau plan régulier, une extrémité de chaque antenne dépassant dudit volume exempt de gaz (4) dans la chambre d'ionisation (1), une boucle d'induction (10) émettant des micro-ondes dans le volume exempt de gaz (4).

2. Dispositif selon la revendication 1, caractérisé par le fait que la longueur des antennes (5,5') est voisine d'un multiple impair du quart de longueur d'ondes de la micro-onde dans le vide.

3. Dispositif selon l'une quelconque des revendications 1 et 2, caractérisé par le fait qu'il comporte en outre des moyens pour générer dans le volume exempt de gaz (4) un champ électrique de polarisation apte à concentrer les ions formés au voisinage de l'ensemble d'antennes métalliques (5,5') sous la forme d'une gaine d'ions.

4. Dispositif selon la revendication 3, caractérisé par le fait que les moyens pour générer le champ électrique de polarisation comprennent l'ensemble d'antennes métalliques (5,5') qui sert à l'application des micro-ondes dans le plasma.

5. Dispositif selon l'une quelconque des revendications 1 à 4, caractérisé par le fait qu'il comporte une unique boucle d'induction (10) pour l'application des micro-ondes dans le volume exempt de gaz (4).

6. Dispositif selon l'une quelconque des revendications 1 à 5, caractérisé par le fait qu'il comporte des aimants permanents (13,13') aptes à générer dans la chambre d'ionisation (1) un champ magnétique statique ($\vec{B}$).

7. Dispositif selon la revendication 6, caractérisé par le fait que les aimants permanents (13') sont placés à l'intérieur des antennes métalliques (5') réalisées sous la forme de tubes creux, lesdits aimants permanents (13') se présentant sous forme de barreaux à aimantation axiale.

8. Procédé pour former un plasma à partir de micro-ondes dans un dispositif selon l'une quelconque des revendications 3 à 7, caractérisé par le fait que l'on ajoute au champ électrique d'excitation un autre champ électrique de polarisation quasi statique tendant à concentrer les ions autour de chacune des antennes (5) émettant les micro-ondes.

**Patentansprüche**

1. Vorrichtung zur Herstellung eines Plasma mit Hilfe von Mikrowellen, mit einer Ionisations-Kammer, in die ein Gas eingeleitet werden kann, das aufgrund der Anwesenheit eines hochfrequenten elektrischen Wechselfeldes erregt wird, das von einer Anzahl metallischer Antennen ausgestrahlt wird, dadurch **gekennzeichnet**, daß sie ein von Gas (4) freies Volumen aufweist, In dem die metallischen Antennen (5,5') parallel zueinander und gleichmäßig verteilt an den Knoten eines ebenen regelmäßigen Netzes angeordnet sind, wobei ein Ende jeder Antenne aus dem von Gas (4) freien Volumen herausragt in die Ionisations-Kammer (1), wobei eine Induktionsschleife (10) Mikrowellen in das von Gas (4) freie Volumen ausstrahlt.

2. Vorrichtung nach Anspruch 1, dadurch **gekennzeichnet**, daß die Länge der Antennen (5,5') in der Nähe eines ungeraden Vielfachen eines Viertels der Wellenlänge der Mikrowellen im luftleeren Raum beträgt.

3. Vorrichtung nach einem der Ansprüche 1 und 2, dadurch **gekennzeichnet**, daß sie im übrigen Mittel zur Erzeugung eines elektrischen Polarisationsfeldes in dem von Gas (4) freien Volumen aufweist, die gestatten, die in der Nahe der Anordnung der metallischen Antennen (5,5') gebildeten Ionen in der Form einer Ionenhülle zu konzentrieren.

4. Vorrichtung nach Anspruch 3, dadurch **gekennzeichnet**, daß die Mittel zur Erzeugung des elektrischen Polarisationsfeldes die Anordnung der metallischen Antennen (5,5') umfassen, die dazu dienen, die Mikrowellen in dem Plasma aufzubringen.

5. Vorrichtung nach einem der Ansprüche 1 bis 4, dadurch **gekennzeichnet**, daß sie eine einzige Induktionsschleife (10) zur Aufbringung der Mikrowellen in dem von Gas (4) freien Volumen aufweist.

6. Vorrichtung nach einem der Ansprüche 1 bis 5, dadurch **gekennzeichnet**, daß sie Permanent-Magneten (13') aufweist, die in der Lage sind, in der Ionisations-Kammer (1) ein statisches magnetisches Feld (B) zu erzeugen.

7. Vorrichtung nach Anspruch 6, dadurch **gekennzeichnet**, daß die Permanent-Magneten (13') im Inneren der metallischen Antennen (5') angeordnet sind, die durch hohle Rohre gebildet werden, welche Permanent-Magneten (13') die Form von axialmagnetischen Stäben aufweisen.

8. Verfahren zur Erzeugung eines Plasma mlt Hilfe von Mikrowellen in einer Vorrichtung gemäß einem der Ansprüche 3 bis 7, dadurch **gekennzeichnet**, daß dem elektrischen Erregerfeld ein anderes elektrisches, quasi statisches Polarisationsfeld überlagert wird, das dazu tendiert, die Ionen um die Antennen (5), die die Mikrowellen ausstrahlen, zu konzentrieren.

**Claims**

1. Device for forming a plasma from microvaves, incorporating an ionization chamber into which a gas can be introduced in order to undergo an excitation due to the presence of a high frequency, alternating, electric field emitted by a plurality of metal antennas, characterized in that it has a gas-free volume (4), in which the said metal antennas (5, 5') are arranged parallel to one another, being distributed at the nodes of a regular, planar network, one end of each antenna projecting beyond said gas-free volume (4) into the ionization chamber (1), an induction loop (10) emitting microwaves into the gas-free volume (4).

2. Device according to claim 1, characterized in that the length of the antennas (5, 5') is close to an uneven multiple of quarter the wavelength of the microwave in the vacuum.

**3.** Device according to either of the claims 1 and 2, characterized in that it also has means for generating in the gas-free volume (4) an electric polarization field able to concentrate the ions formed in the vicinity of the group of metal antennas (5, 5') in the form of an ion shell.

**4.** Device according to claim 3, characterized in that the means for generating the electric polarization field comprise the group of metal antennas (5, 5') used for applying the microwaves to the plasma.

**5.** Device according to any one of the claims 1 to 4, characterized in that it has a single induction loop (10) for applying microwaves to the gas-free volume (4).

**6.** Device according to any one of the claims 1 to 5, characterized in that it has permanent magnets (13, 13') able to generate a static magnetic field ($\vec{B}$) into the ionization chamber (1).

**7.** Device according to claim 6, characterized in that the permanent magnts (13, 13') are placed within metal antennas (5') in the form of hollow tubes, said permanent magnets (13') being in the form of bars with axial magnetization.

**8.** Process for farming a plasma from microwaves in a device according ta any one of the claims 3 to 7, characterized in that to the electric excitation field is added another quasi-static, electric polarization field concentrating the ions around each of the antennas (5) emitting microwaves.

FIG.1

FIG.2

FIG.3